# EUROPEAN PATENT APPLICATION

(11) **EP 2 184 791 A1**
(43) Date of publication of application: **12.05.2010**
(21) Application number: 09176655.0
(22) Date of filing: 20.11.2009
(51) Int. Cl.: H01L 41/113, B62J 6/06

(54) **Electrical power generation device for bicycles**

(71) Applicant: BMC Trading AG, 2540 Grenchen (CH)
(72) Inventor: Bächler, Herbert, 8706, Meilen (CH)
(74) Representative: Troesch Scheidegger Werner AG

(57) **Abstract**

An electrical power generation device for bicycles is disclosed. Said electrical power generation device comprises one or more magnetic elements (4) to be propellably attached to a bicycle and an energy conversion unit (1) to be fixedly attached to the bicycle, where the energy conversion unit (1) includes a piezoelectric transducer (2) operatively connected to a ferromagnetic piece (3), the one or more magnetic elements (4) being arranged to be moveable past the ferromagnetic piece (3) such that a magnetic force is exertable on the ferromagnetic piece (3), the ferromagnetic piece (3) being deflectable when the one or more magnetic elements (4) are located in close proximity of the ferromagnetic piece (3). The mechanical stress/strain imposed on the piezoelectric transducer (2) when it is bent due to the deflection of the ferromagnetic piece (3) generates a voltage (V) across the terminals of the piezoelectric transducer (2), which is subsequently converted into usable electrical power.

## Description

### Technical field

The present invention pertains to an electrical power generation device, especially for bicycles.

### Background of the invention

Modern bicycles often have a number of different devices which require an electrical power supply. Bicycle lights typically have a relatively high power consumption and are therefore frequently powered by a dynamo. Drawbacks of dynamos include the considerable extra driving force that needs to be provided by the bicyclist in order to propel the dynamo, the additional rolling resistance they create when in operation, their bulkiness, the notable sound they produce as well as the fact that they often function poorly during rain because the rotor which runs on the side of the tire tends to slip under wet conditions. The use of a battery to power the lights has the disadvantage of a limited lifetime along with the downside of not being eco-friendly.

The German patent application DE 42 29 457 Al discloses an alternative apparatus for electrical power generation as a possible replacement of such dynamos. This apparatus comprises a horseshoe shaped permanent magnet arranged such that its arms extend over the bicycle wheel rim to which magnetisable metal pieces are attached in regular intervals. When these magnetisable metal pieces pass between the arms of the horseshoe shaped permanent magnet during rotation of the wheel, the length of the air gap is reduced causing a change in magnetic resistance of the magnetic circuit. The variation of the magnetic flux within the magnetic circuit is used to induce a voltage in a coil that embraces part of the horseshoe shaped permanent magnet, which voltage is then provided to the electrical loads, e.g. the lights.

The power consumption of present day electronic devices employed in conjunction with bicycles, such as for instance bicycle computers, navigation or position logging systems, sensors, wireless transmitters, etc., is typically on the order of a few milliwatts. Usually, such devices are each separately powered by a button cell battery. The drop out of a battery during a cycling tour is annoying and the replacement can be a tedious task, especially for devices that are hard to reach, such as for example a senor that is integrated into the bicycle. Furthermore, abandoning the use of batteries is highly desirable in view of their ecologically problematic disposal.

### Summary of the invention

It is therefore an object of the present invention to provide an alternative, reliable means for powering electronic devices, which is essentially self-sustaining and specifically does away with the need for periodic battery replacement.

This object is achieved in particular by means of the characterising features of the independent claim. Further advantageous embodiments are mentioned in the dependent claims and presented in the description.

The present invention is directed to an electrical power generation device for bicycles comprising one or more magnetic elements to be propellably attached to a bicycle and an energy conversion unit to be fixedly attached to the bicycle, where the energy conversion unit comprises a piezoelectric transducer operatively connected to a ferromagnetic piece, the one or more magnetic elements being arranged to be moveable past the ferromagnetic piece such that a magnetic force is exertable on the ferromagnetic piece, the ferromagnetic piece being deflectable when the one or more magnetic elements are located in close proximity of the ferromagnetic piece. Deflection of the ferromagnetic piece imposes mechanical stress/strain on the piezoelectric transducer operatively connected to the ferromagnetic piece, which leads to the generation of a voltage across the piezoelectric transducer due to the piezoelectric effect. In contrast to the case when using a typical sidewall-running bottle dynamo, the propulsion of the one or more magnetic elements past the piezoelectric transducer does not require a noticeable amount of effort and energy from the bicyclist.

In a specific embodiment of the present invention the energy conversion unit constitutes a module further comprising a second piezoelectric transducer operationally connected to a second ferromagnetic piece, the first and second ferromagnetic pieces, respectively, being associated with a first and second set of one or more magnetic elements, respectively, to be arranged to move past the first and second ferromagnetic piece, respectively. Such a configuration allows integration of two transducers, each being driven by a separate set of one or more magnetic elements, into a single module, thus providing redundancy and therewith additional reliability as well as the possibility to produce more electrical energy at once.

According to a specific embodiment of the present invention the piezoelectric transducer comprises a piezoelectric layer attached to a bendable mechanical structure, such as for example a cantilever beam or plate. The mechanical structure is to be securely attached to the bicycle at one end and has the ferromagnetic piece attached to the opposite end. Such a configuration allows to achieve high levels of stress/strain in the piezoelectric layer in order to make maximal use of the piezoelectric effect by employing a simple and robust mechanical structure to convey the magnetic force exerted on the ferromagnetic piece to the piezoelectric layer.

In a further embodiment of the present invention the ferromagnetic piece is adjustably attached to the mechanical structure. This allows adjustment of the position of the ferromagnetic piece relative to the one or more magnetic elements in order to achieve an alignment such that the magnetic force has the desired impact on the ferromagnetic piece. Furthermore, adjustment of the position of the ferromagnetic piece along the bendable mechanical structure, e.g. a cantilever beam, allows to tune the oscillation characteristics of the mechanical structure in order to achieve maximal mechanical to electrical energy conversion in the piezoelectric layer.

It is an aspect of the present invention that the piezoelectric layer is made of a piezoelectric material such as for instance a piezoelectric ceramic, e.g. lead zirconate titanate (PZT), barium titanate, lead titanate, potassium niobate, lithium niobate, lithium tantalate or sodium tungstate, or a lead-free piezoelectric ceramic, e.g. sodium potassium niobate, or a piezoelectric polymer, e.g. polyvinylidene fluoride (PVDF), preferably PZT or PVDF.

In another embodiment of the present invention the energy conversion unit further comprises a capacitive voltage converter and preferably also an energy storage means, such as for instance a rechargeable battery or a super/ultra capacitor, together with a corresponding charging circuit. The output of the piezoelectric transducer consists of a fluctuating high voltage signal. The devices that need to be powered typically require a stable low DC (direct current) voltage. Therefore, the capacitive voltage converter reduces the voltage to a usable level. Since the piezoelectric transducer only produces energy when the bicycle is in motion, an energy storage means is essential in order to provide uninterrupted power to those electrical loads which are in continuous use. Hence, a charging circuit should also be part of the energy conversion unit to charge a rechargeable battery or a super/ultra capacitor which forms the actual power source for the electrical loads.

As indicated in the following, many different embodiments of the present invention are conceivable with respect to the mounting of the energy conversion unit and mounting of the one or more magnetic elements on the bicycle. In connection with this issue it is important that the propelled "moving part" of the electrical power generation device, i.e. the one or more magnetic elements, be arranged in such a way relative to the "fixed part", i.e. the energy conversion unit, that the one or more magnetic elements repeatedly are brought into close (but not immediate) contact with the ferromagnetic piece when the bicycle is in motion, so that the one or more magnetic elements can exert a sufficiently strong magnetic force on the ferromagnetic piece in order to deflect it. This is most readily achieved by attaching the "moving part" to a rotatable part of the bicycle, propellable by the bicyclist, and installing the "fixed part" on a nearby part of the bicycle frame or of the front fork.

According to specific embodiments of the present invention the energy conversion unit is fixedly attached to one of the front fork blades or one of the chain stays or one of the seat stays or the seat tube or the down tube or the front hub or the rear hub of the bicycle.

According to further specific embodiments of the present invention the energy conversion unit is integrated into the frame or the fork or the front hub or the rear hub of the bicycle. By integrating the energy conversion unit into any of the said components of the bicycle the energy conversion unit is protected from the environment, which could otherwise for instance cause outages because of clogging by dirt, malfunction due to penetration of water, or damage as a result of mechanical mistreatment and rough handling. Such integration is made possible thanks to the increased use of carbon (composite) and aluminium for constructing light weight bicycles, i.e. materials which do not overly impact the magnetic force traversing them, i.e. from the magnetic elements to the ferromagnetic piece.

Accordingly, the one or more magnetic elements are attached to the front or rear wheel and/or the chainwheel and/or the left and/or right crank of the bicycle.

According to yet further specific embodiments of the invention the energy conversion module is fixedly attached to or integrated into one of the chain stays of the bicycle. This placement is especially suitable for an energy conversion module comprising two piezoelectric transducers each operationally connected to a different ferromagnetic piece, where each ferromagnetic piece is associated with a separate set of one or more magnetic elements. The chain stays are ideally located for positioning such a dual transducer module since two rotating parts, namely the rear wheel and the chainwheel or the cranks, are within reach for separately arranging the two sets of one or more magnetic elements.

According to another specific embodiment of the invention the one or more magnetic elements are adjustably attached to the spokes of the front or rear wheel of the bicycle. This allows adjustment of the position of the one or more magnetic elements relative to the ferromagnetic piece in order to achieve an alignment such that the magnetic force has the desired impact on the ferromagnetic piece.

According to a further specific embodiment of the present invention the one or more magnetic elements are attached to or integrated into the wheel rim of the front wheel and/or the rear wheel of the bicycle.

According to yet another specific embodiment of the present invention the multiple magnetic elements are mounted, preferably at uniform intervals to one another, on a ring, disc or wheel-like shaped holder, which is attachable to the spindle of the front or rear wheel or to the bottom bracket spindle, or alternatively can be secured to the spokes of the front or rear wheel of the bicycle. This simplifies mounting of the magnets on the bicycle, ensures that they remain at a fixed position to one another and relative to the bicycle, and allows to protect the magnetic elements if they are encased in the holder, e.g. by moulding them into a holder made of for instance a plastic material.

In a further specific embodiment of the present invention the energy conversion unit further comprises a wireless transmitter. The electrical power generation device according to this embodiment of the present invention can then be used to wirelessly send information to a remote display, processing or storage device such as for example a bicycle computer, a personal digital assistant (PDA), a mobile telephone, etc.

In yet a further specific embodiment of the present invention the energy conversion unit further comprises an accelerometer. The electrical power generation device according to this embodiment of the present invention can be used to register movements of the bicycle.

In yet another specific embodiment of the present invention the energy conversion unit further comprises a geo-spatial positioning/localisation module, including for example a receiver for signals from the GPS, GLONASS or Galileo satellite based system. The position/location information can be sent wirelessly to a remote display, processing or storage device using the wireless transmitter mentioned previously comprised in the energy conversion unit, and then be employed for navigation purposes or for instance to provide information regarding speed, distance travelled, rate of climb or decent, traversed difference in altitude, etc. Alternatively the position/location information can be stored (logged) in a memory of the positioning/localisation module and read out at a later time, e.g. after a cycling trip, via an appropriate interface such as a USB interface by means of a cable or wirelessly employing the wireless transmitter comprised in the energy conversion unit.

The electrical power generation device according to the present invention can especially be used to power a bicycle computer attached to the bicycle.

The electrical power generation device according to certain embodiments of the present invention can additionally be used as a sensor for a tachometer for determining the revolutions per minute (RPM) of the front and/or rear wheel or the chainwheel. This can be done by detecting with an appropriate electronic circuit the voltage peaks produced by the piezoelectric transducer at each passage of a magnetic element past the ferromagnetic piece. The RPM can then be calculated from the repetition rate of these voltage peaks and the known arrangement of the magnetic elements on the rotating part of the bicycle. The previously mentioned energy conversion module comprising two piezoelectric transducers is especially well suited as a sensor for a tachometer for concurrently and independently determining the RPM of both the rear wheel and the chainwheel when the energy conversion module is positioned at the chain stays and the two sets of one or more magnetic elements are attached to the rear wheel and the chainwheel.

It is expressly pointed out that any combination of the above-mentioned or hereafter described embodiments is feasible. Of course, the combinations of embodiments that would result in contradictions are excluded.

The present invention is further described in detail in the following by way of examples of specific embodiments. These embodiments are for illustrative purposes only and shall in no way be used to limit the scope of the present invention. Additional features of the invention will also become apparent to those skilled in the art upon consideration of the following detailed description of embodiments.

### Description of the drawings

For the purpose of facilitating and explaining the present invention, preferred embodiments thereof are illustrated in the accompanying drawings to be considered in connection with the following description. The drawings will help to readily understand and appreciate the present invention, where:
- Fig. 1: shows a conceptual representation of an embodiment of the present invention;
- Fig. 2: shows possible locations on a bicycle for attaching the magnetic elements and the energy conversion unit according to several embodiments of the present invention; and
- Fig. 3: shows an arrangement of multiple magnetic elements on a) a ring, b) a disc and c) a wheel-like shaped holder intended for use as part of specific embodiments of the present invention.

### Detailed description of the invention

The invention makes use of the piezoelectric effect, whereby mechanical stress/strain applied to a structure made of piezoelectric material such as PZT or PVDF causes a charge asymmetry within the material, thus generating a voltage across the material which can be converted into usable electrical power.

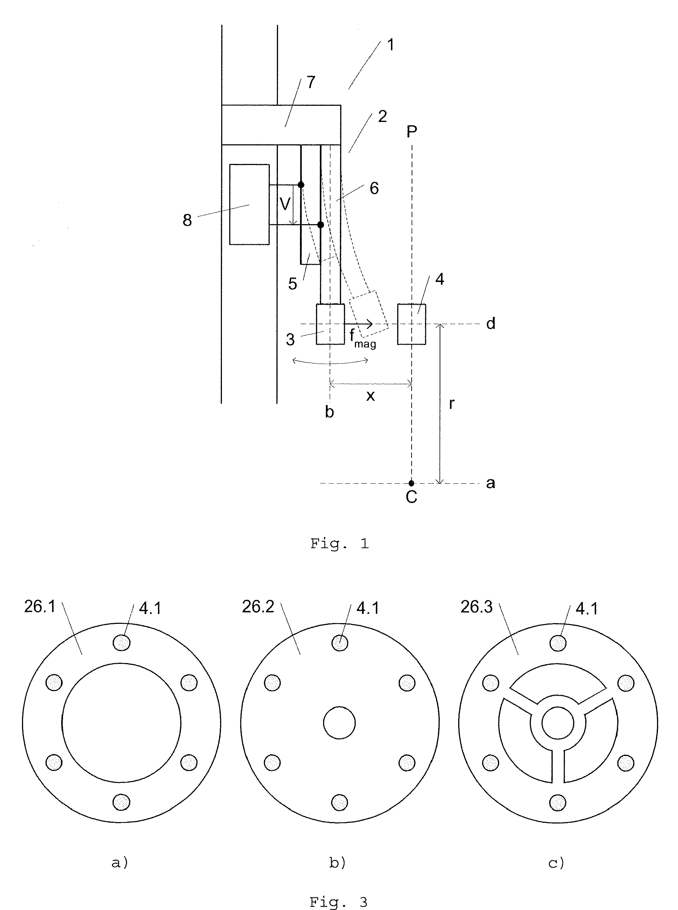

Fig. 1 shows a conceptual arrangement that puts this principle into use for generating electrical power for a bicycle using an energy conversion unit 1, comprising a piezoelectric transducer 2 and a ferromagnetic piece 3, employed in conjunction with one or more magnetic elements 4. For this purpose a piezoelectric transducer 2 comprising a piezoelectric layer 5 is attached to a bendable mechanical structure, such as for instance a cantilever beam 6 or plate, which at one end is securely attached to the bicycle, e.g. by means of a clamp 7, and which has the ferromagnetic piece 3 attached to the opposite end. The one or more magnetic elements 4 are arranged on the bicycle such that they can be propelled past the ferromagnetic piece 3. To achieve this, the one or more magnetic elements 4 are attached to a part of the bicycle that can be propelled by the bicyclist, e.g. that can set into and maintained in motion by the bicyclist by operating the pedals 22, whereas the ferromagnetic piece 3 is deflectably attached to a location of the bicycle where the one or more magnetic elements 4 repeatedly pass by and come into close contact with the ferromagnetic piece 3 without actually touching it. An exemplary geometric configuration of such an arrangement is illustrated in Fig. 1, which shows a magnetic element 4 rotatable about the rotation axis a in the plane P at a distance r from the centre of rotation C. When no force is applied to the ferromagnetic piece 3 it rests in its stationary position located along the axis b of the cantilever beam 6 at a distance x from the plane of rotation P. Whilst in the proximity of the ferromagnetic piece 3 the magnetic element 4 exerts a strong enough magnetic force f_{mag} on the ferromagnetic piece 3, such that the ferromagnetic piece 3 is deflected from its stationary position and attracted towards the magnetic element 4, resulting in a reduction of the distance x between the ferromagnetic piece 3 and the plane of rotation P. This deflection of the ferromagnetic piece 3 causes the cantilever beam 6 to bend, which in turn imposes mechanical stress/strain on the piezoelectric layer 5 attached to the cantilever beam 6, thus leading to the generation of a voltage V across the piezoelectric material. As soon as the magnetic element 4 leaves the close proximity of the ferromagnetic piece 3 the magnetic force f_{mag} rapidly subsides and the shape restoring elastic forces within the material of the cantilever beam 6 pull the ferromagnetic piece 3 back towards its stationary position where it can come to a temporary rest, following a number of oscillations back and forth across the axis b depending mainly on the stiffness of the cantilever beam 6 and the mass of ferromagnetic piece 3. Subsequent passages of a magnetic element 4 lead to a repetition of this cycle.

The resulting fluctuating high voltage V at the terminals of the piezoelectric transducer 2 is then converted into a stable low DC voltage with the aid of a capacitive voltage converter 8.

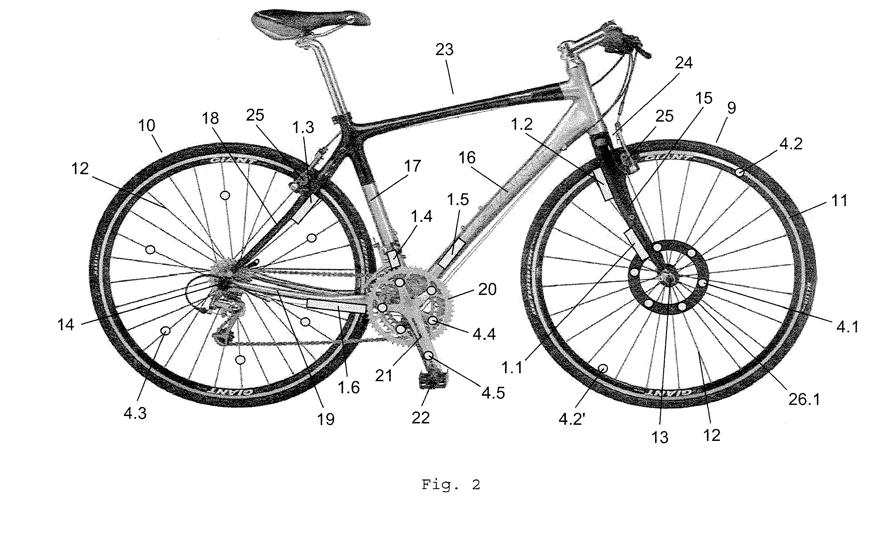

There are many options for arranging the inventive electrical power generation device on a bicycle. Fig. 2 depicts a number of possible solutions according to the present invention. In principle the energy conversion unit 1.1, 1.2, 1.3, 1.4, 1.5, 1.6 is attached to a part of the bicycle frame 23 or the blades 15 of the front fork 24 and the one or more magnetic elements 4.1, 4.2, 4.2', 4.3, 4.4, 4.5 are attached to a rotatable part of the bicycle, such as the wheels 9, 10 or the chainwheel 20 or the cranks 21, which can be propelled by the bicyclist through pedalling. Additionally, the energy conversion unit 1 could also be attached to a carrier or a mudguard of the bicycle (both not shown in Fig. 2).

According to an embodiment of the present invention illustrated in Fig. 2 the energy conversion unit 1.1 is attached to the lower part of one of the blades 15 of the front fork 24 of the bicycle. The energy conversion unit 1.1 can be attached to the bicycle by means of screws, a clamp, a snap fit, a strap, etc. By positioning the energy conversion unit 1.1 on the rear side (i.e. facing the pedals 22) of the right (or left) blade 15 as illustrated in Fig. 2 it is in the slipstream and protected against the oncoming flow of air. However, the energy conversion unit 1.1 can also be positioned on the front side or the inward side (i.e. facing the front wheel 9) of one of the blades 15. The associated set of magnetic elements 4.1 are mounted at uniform intervals to one another on a ring shaped holder 26.1 as shown in Fig. 3 a), which is secured to the spokes 12 of the front wheel 9. The magnetic elements 4.1 can for instance be glued on to or force fitted or moulded into a plastic holder. Alternatively, cylindrically shaped magnetic elements 4.1 provided with a thread at the lateral surface can be screw fitted into a holder 26.1 provided with a corresponding mating thread. With the latter arrangement the protrusion of the cylindrically shaped magnetic elements 4.1 from the holder 26.1 can easily be adjusted by screwing in or out the cylindrically shaped magnetic elements 4.1, thus allowing to precisely set the distance (x according to Fig. 1) between the cylindrically shaped magnetic elements 4.1 and the ferromagnetic piece 3 in order to optimise the operation of the energy conversion unit 1.1. As an alternative, the holder 26.1 can be made of a ferromagnetic material which allows the magnetic elements 4.1 to be attached to the holder 26.1 be means of the magnetic force between the magnetic elements 4.1 and the holder 26.1. Such an arrangement allows ease and quick replacement as well as flexible mounting of the magnetic elements 4.1 whilst also providing a simple possibility for adapting the configuration of the magnetic elements 4.1 to different needs. Instead of a ring shaped holder 26.1, which is secured to the spokes of the front wheel 9, a disc shaped holder 26.2 or a wheel-like shaped holder 26.3, respectively, as shown in Fig. 3 b) and Fig. 3 c), respectively, can be employed. These two holder types 26.2, 26.3 can be attached to the spindle of the front wheel 9 so that the holder 26.2, 26.3 rotates together with the front wheel 9.

According to a further embodiment of the present invention also illustrated in Fig. 2 the energy conversion unit 1.2 is attached to the upper part of one of the blades 15 of the front fork 24 of the bicycle. The associated set of one or more magnetic elements 4.2, 4.2' is then attached to the wheel rim 12 of the front wheel 9. Depending on the type of brake 25 being used the magnetic elements are either attached to the face of the rim (see 4.2 in Fig. 2) or to the surface of the rim facing the spokes 12 (see 4.2' in Fig. 2) in order not to interfere with the brake shoes. Interference with the brake shoes is also avoided by integrating the magnetic elements 4.2 into the face of the rim 11 such that they are flush with the surface of the rim 11 or counter-sunk into the rim 11.

According to another embodiment of the present invention also illustrated in Fig. 2 the energy conversion unit 1.3 is attached to the upper part of one of the seat stays 18 of the bicycle. The associated one or more magnetic elements 4.3 are then individually and adjustably attached to the spokes 12 of the rear wheel 10. By moving the individual magnetic elements 4.3 along the spokes 12 their radial position can be set to align with the ferromagnetic piece 3 of the energy conversion unit 1.3, i.e. such that the magnetic elements 4.3 are located at a radius r from the rear wheel spindle (= centre of rotation C) in order to intersect during rotation with the axis d, along which the ferromagnetic piece 3 is located, as illustrated in Fig. 1.

According to yet another embodiment of the present invention also illustrated in Fig. 2 the energy conversion unit 1.4 is attached to the lower part of seat tube 17 of the bicycle. The associated set of magnetic elements 4.4 is then attached to or integrated into the chainwheel 20. Mounting of the magnetic elements 4.4 to the chainwheel 20 may be done for instance in any of the ways described previously in conjunction with mounting magnetic elements 4.1 on the ring, disc or wheel-like shaped holder 26.1, 26.2 or 26.3. Alternatively, the magnetic elements 4.4 can be mounted on a disc or wheel-like shaped holder 26.2 or 26.3, which is attached to the bottom bracket spindle (on the left or right side of the frame 23) so that the holder 26.2, 26.3 rotates together with the chainwheel 20. Since the seat tube 17 has a relatively large diameter it is well suited to accommodate the energy conversion unit 1.4 within the tube. If the energy conversion unit 1.4 is integrated into the seat tube 17, the seat tube 17 should be made of a none-ferromagnetic material, e.g. carbon (composite) or aluminium, in order not to overly weaken the magnetic force f_{mag} exerted on the ferromagnetic piece 3 of the energy conversion unit 1.4 by the magnetic elements 4.4.

According to yet a further embodiment of the present invention also illustrated in Fig. 2 the energy conversion unit 1.5 is attached to the lower part of down tube 16 of the bicycle. The associated set of magnetic elements 4.5 is then attached to or integrated into the left and/or right crank 21. Again, since the down tube 16 has a relatively large diameter it is well suited to accommodate the energy conversion unit 1.4 at its interior.

According to yet another further embodiment of the present invention also illustrated in Fig. 2 the energy conversion unit constitutes a module 1.6 comprising two energy conversion units 1, which energy conversion module 1.6 is attached to a chain stay 19 of the bicycle. A separate set of magnetic elements 4.3 & 4.4, 4.5 is associated with each of the two energy conversion units 1, both units 1 having their own ferromagnetic piece 3. By attaching the energy conversion module 1.6 to one of the chain stays 19 it is conveniently located to operatively interact with two individual sets of magnetic elements 4.3 & 4.4, 4.5, where one set is attached to the spokes 12 of the rear wheel 10 and the other set is attached to the chainwheel 20 and/or the chranks 21.

### List of reference symbols

- 1, 1.1-5: energy conversion unit
- 1.6: energy conversion module
- 2: piezoelectric transducer
- 3: ferromagnetic piece
- 4, 4.1-5, 4.2': magnetic element(s)
- 5: piezoelectric layer
- 6: cantilever beam
- 7: clamp
- 8: capacitive voltage converter
- 9: front wheel
- 10: rear wheel
- 11: wheel rim
- 12: spike
- 13: front hub
- 14: rear hub
- 15: blade of the front fork
- 16: down tube
- 17: seat tube
- 18: seat stay
- 19: chain stay
- 20: chainwheel
- 21: crank
- 22: pedal
- 23: frame
- 24: fork
- 25: brake
- 26.1-3: holder for magnetic elements

## Claims

1. Electrical power generation device for bicycles comprising one or more magnetic elements (4, 4.1, 4.2, 4.2', 4.3, 4.4, 4.5) to be propellably attached to a bicycle and an energy conversion unit (1, 1.1, 1.2, 1.3, 1.4, 1.5, 1.6) to be fixedly attached to the bicycle, **characterised in that** the energy conversion unit (1, 1.1., 1.2, 1.3, 1.4, 1.5, 1.6) comprises a piezoelectric transducer (2) operatively connected to a ferromagnetic piece (3), the one or more magnetic elements (4, 4.1, 4.2, 4.2', 4.3, 4.4, 4.5) being arranged to be moveable past the ferromagnetic piece (3) such that a magnetic force is exertable on the ferromagnetic piece (3), the ferromagnetic piece (3) being deflectable when the one or more magnetic elements (4, 4.1, 4.2, 4.2', 4.3, 4.4, 4.5) are located in close proximity of the ferromagnetic piece (3).

2. Electrical power generation device according to claim 1, **characterised in that** the energy conversion unit constitutes a module (1.6) further comprising a second piezoelectric transducer (1) operationally connected to a second ferromagnetic piece (3), the first and second ferromagnetic pieces (3), respectively, being associated with a first and second set of one or more magnetic elements (4.3 & 4.4, 4.5), respectively, to be arranged to be moveable past the first and second ferromagnetic piece (3), respectively.

3. Electrical power generation device according to claim 1 or 2 **characterised in that** the/each piezoelectric transducer (2) comprises a piezoelectric layer (5) attached to a bendable mechanical structure, such as for example a cantilever beam (6) or plate, which mechanical structure is to be securely attached to the bicycle at one end and has the ferromagnetic piece (3) attached to the opposite end.

4. Electrical power generation device according to claim 3, **characterised in that** the ferromagnetic piece (3) is adjustably attached to the mechanical structure.

5. Electrical power generation device according to claim 3 or 4, **characterised in that** the piezoelectric layer (5) is made of a piezoelectric material such as for instance a piezoelectric ceramic, e.g. lead zirconate titanate (PZT), barium titanate, lead titanate, potassium niobate, lithium niobate, lithium tantalate or sodium tungstate, or a lead-free piezoelectric ceramic, e.g. sodium potassium niobate, or a piezoelectric polymer, e.g. polyvinylidene fluoride (PVDF), preferably PZT or PVDF.

6. Electrical power generation device according to one of the preceding claims, **characterised in that** the energy conversion unit (1, 1.1, 1.2, 1.3, 1.4, 1.5, 1.6) further comprises a capacitive voltage converter (8) and preferably also energy storage means, such as for instance a rechargeable battery or a super/ultra capacitor, together with a corresponding charging circuit.

7. Electrical power generation device according to one of the preceding claims, **characterised in that** the energy conversion unit (1, 1.1, 1.2, 1.3, 1.4, 1.5, 1.6) further comprises a wireless transmitter and/or an accelerometer and/or a geo-spatial positioning or localisation module, including for example a receiver for signals from the GPS, GLONASS or Galileo satellite based system.

8. Electrical power generation device according to one of the preceding claims connected with a bicycle computer attached to the bicycle for providing the bicycle computer with electrical power.

9. Bicycle with an electrical power generation device according to one of the claims 1 to 8, **characterised in that** the energy conversion unit (1, 1.1, 1.2, 1.3, 1.4, 1.5, 1.6) is fixedly attached to a front fork blade (15) or a chain stay (19) or a seat stay (18) or a seat tube (17) or a down tube (16) or a front hub (13) or a rear hub (14) of the bicycle.

10. Bicycle with an electrical power generation device according to one of the claims 1 to 8, **characterised in that** the energy conversion unit (1, 1.1, 1.2, 1.3, 1.4, 1.5, 1.6) is integrated into a frame (23) or a fork (24) or a front hub (13) or a rear hub (14) of a bicycle.

11. Bicycle with an electrical power generation device according to one of the claims 1 to 8, **characterised in that** the energy conversion module (1.6) is fixedly attached to or integrated into a chain stay (19) of a bicycle.

12. Bicycle with an electrical power generation device according to one of the claims 1 or 8, **characterised in that** the one or more magnetic elements (4, 4.1, 4.2, 4.2', 4.3, 4.4, 4.5) are attached to a front wheel (9) and/or a rear wheel (10) and/or a chainwheel (20) and/or a left and/or a right crank (21) of a bicycle.

13. Bicycle with an electrical power generation device according to claim 12, **characterised in that** the one or more magnetic elements (4.3) are adjustably attached to spokes (12) of the front wheel (9) or the rear wheel (10) of the bicycle.

14. Bicycle with an electrical power generation device according to claim 12, **characterised in that** the one or more magnetic elements (4.2, 4.2') are attached to or integrated into the wheel rim (11) of the front wheel (9) and/or the rear wheel (10) of the bicycle.

15. Bicycle with an electrical power generation device according to claim 12, **characterised in that** multiple magnetic elements (4.1) are mounted, preferably at uniform intervals to one another, on a ring or a disc or a wheel-like shaped holder (26.1, 26.2, 26.3), which is attachable to a spindle of the front wheel (9) or rear wheel (10) or to a bottom bracket spindle of the bicycle.
